(19) Europäisches Patentamt / European Patent Office / Office européen des brevets

(11) **EP 4 027 763 B1**

(12) **EUROPEAN PATENT SPECIFICATION**

(45) Date of publication and mention
of the grant of the patent:
**21.08.2024 Bulletin 2024/34**

(21) Application number: **19943931.6**

(22) Date of filing: **02.09.2019**

(51) International Patent Classification (IPC):
*H05K 13/04* (2006.01)        *H05K 13/02* (2006.01)
*H05K 13/08* (2006.01)

(52) Cooperative Patent Classification (CPC):
**H05K 13/0408; H05K 13/0813**

(86) International application number:
**PCT/JP2019/034341**

(87) International publication number:
**WO 2021/044458 (11.03.2021 Gazette 2021/10)**

(54) **COMPONENT HOLDING APPARATUS**

BAUTEILHALTEVORRICHTUNG

APPAREIL DE MAINTIENT DE COMPOSANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.07.2022 Bulletin 2022/28**

(73) Proprietor: **Fuji Corporation
Chiryu-shi, Aichi 472-8686 (JP)**

(72) Inventors:
• **ISHIKAWA Kazuma
Chiryu-shi, Aichi 472-8686 (JP)**

• **SUGIHARA, Akio
Chiryu-shi, Aichi 472-8686 (JP)**

(74) Representative: **Grünecker Patent- und
Rechtsanwälte
PartG mbB
Leopoldstraße 4
80802 München (DE)**

(56) References cited:
**WO-A1-2015/186188      JP-A- 2008 227 069
JP-A- 2016 219 473      US-A1- 2017 196 131**

# Description

## Technical Field

The present invention relates to a component holding apparatus for holding a component on a stage on which components are scattered to pick it up therefrom.

## Background Art

As described in the following patent literatures, there are some component holding apparatuses for holding a component on a stage on which components are scattered to pick it up therefrom.

Patent Application US 2017/0196131 A1 relates to component mounting, with components being scattered on a tray at different orientation and picked up therefrom by a component head. A component holding apparatus has a component support surface on which components are disposed in a scattered manner with different orientations. A camera captures an image of the scattered components of the same type. Component data that area stored include a pick up height for different orientations of the same component type. Based on the component data, the captured image is processed to find a target component with a matched shape, and its orientation and xy position is determined. The target component is then held by a component head (nozzle) at the pickup height, xy position, and orientation.

## Patent Literature

Patent Literature 1: International Publication No. WO2015/186188
Patent Literature 2: JP-A-2016-219473

## Summary of the Invention

## Technical Problem

A technical problem to be solved by the present invention is how to suitably hold a component on a stage on which components are scattered to pick it up therefrom.

## Solution to Problem

The present invention is defined by the features of the independent claim, with preferred embodiments being specified in the dependent claims. References to embodiments which do not fall under the scope of the claims are to be understood as examples useful for understanding the invention.

## Advantageous Effect of the Invention

With the component holding apparatus of the present disclosure, the components of one type, which are scattered on the stage, are held based on the inputted multiple heights of the components of one type and the image data captured by the imaging device. As a result, the components can suitably be held to be picked up from the stage on which the components are scattered.

## Brief Description of Drawings

Fig. 1 is a perspective view showing a component mounter.
Fig. 2 is a perspective view showing a component mounting device of the component mounter.
Fig. 3 is a perspective view showing a bulk component supply device.
Fig. 4 is a perspective view showing a component supply unit.
Fig. 5 is a see-through view showing an interior of the component supply unit.
Fig. 6 is a see-through view showing a part of the interior of the component supply unit.
Fig. 7 is a perspective view showing a component feeder.
Fig. 8 is a perspective view showing a component scattering device.
Fig. 9 is a perspective view showing the component scattering device.
Fig. 10 is a perspective view showing a component holding head.
Fig. 11 is a diagram showing a component receiving member, which is now accommodating an electronic circuit component.
Fig. 12 is a block diagram showing a control device of the component mounter.
Fig. 13 is a diagram showing a component support member on which lead components are scattered as viewed from above.
Fig. 14 is a conceptual diagram for explaining a calculation method of an actual component position of a component based on image data.
Fig. 15 shows a plan view and a side view both showing an identical component.
Fig. 16 is a conceptual diagram for explaining a calculation method of an actual component position of a component based on image data.
Fig. 17 is a diagram showing conceptually a calculated component holding position and an expected holding position.
Fig. 18 is a diagram showing conceptually a calculated component holding position and an expected holding position.
Fig. 19 is a diagram showing an input screen.
Fig. 20 is a diagram showing conceptually a calculated component holding position and an expected holding position.

Fig. 21 shows a plan view and a side view both showing the component shown in Fig. 15, which is now being oriented differently from the orientation shown Fig. 15.

Fig. 22 shows a plan view and a side view both showing an identical component.

Fig. 23 shows a plan view and a side view both showing the component shown in Fig 22, which is now being oriented differently from the orientation shown in Fig.22.

Description of Embodiments

Hereinafter, as a mode for carrying out the present invention, an embodiment of the present invention will be described by reference to drawings.

(A) Configuration of Component Mounter

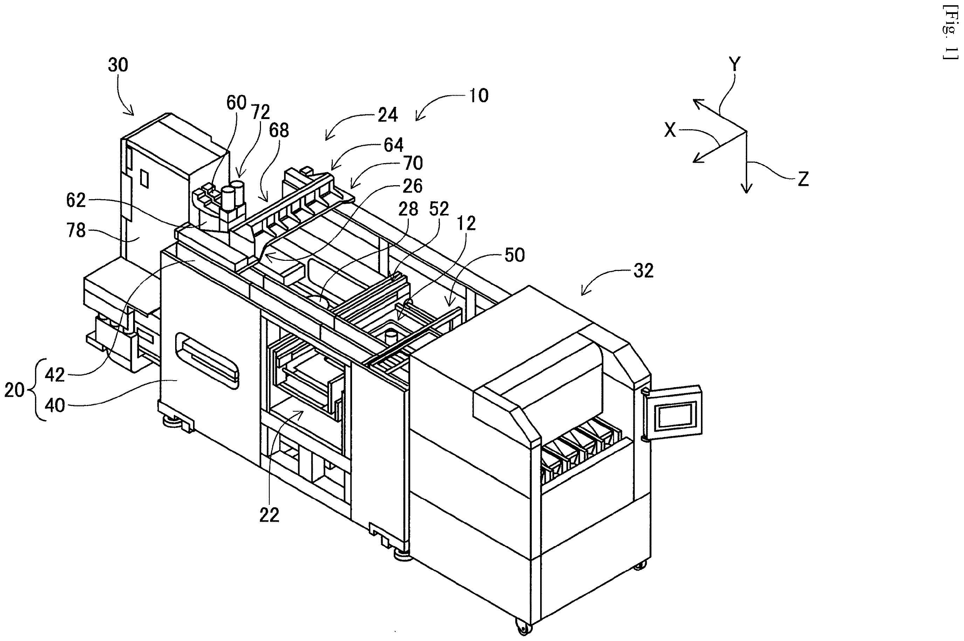

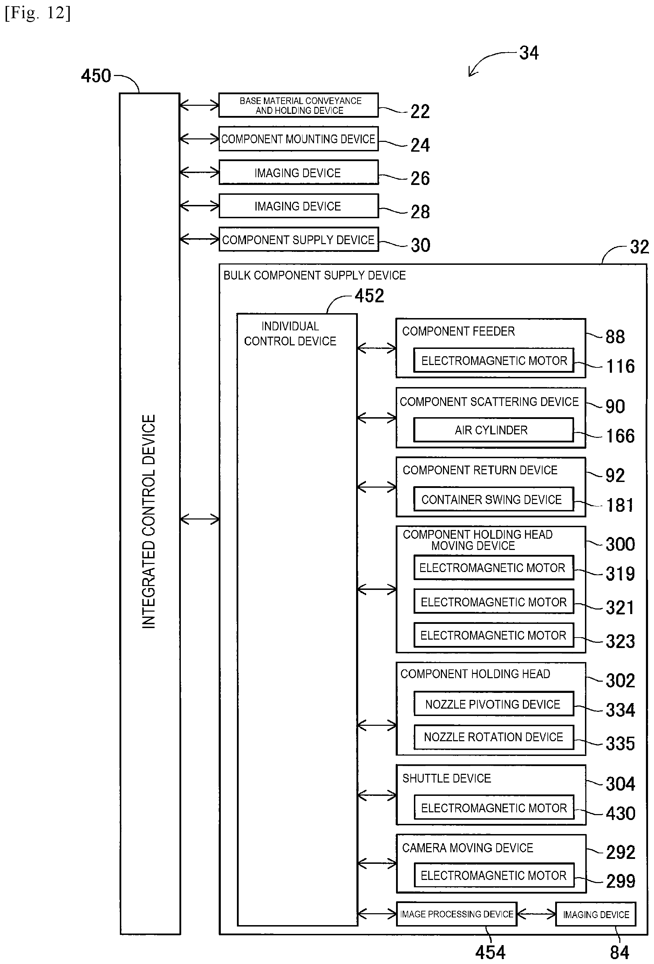

Fig. 1 shows component mounter 10. Component mounter 10 is a device for executing a component mounting operation on circuit base material 12. Component mounter 10 includes device main body 20, base material conveyance and holding device 22, component mounting device 24, imaging devices 26, 28, component supply device 30, bulk component supply device 32, and control device (refer to Fig. 12) 34. Examples of circuit base material 12 include a circuit board, a base material having a three-dimensional structure, and the like, and examples of the circuit board include a printed wiring board, a printed circuit board, and the like.

Device main body 20 is made up of frame 40 and beam 42 that is placed on frame 40. Base material conveyance and holding device 22 is disposed at a center of frame 40 in a longitudinal direction thereof and includes conveyance device 50 and clamp device 52. Conveyance device 50 is a device for conveying circuit base material 12, and clamp device 52 is a device for holding circuit base material 12. As a result, base material conveyance and holding device 22 conveys circuit base material 12 and holds circuit base material 12 fixedly in a predetermined position. In the following description, a conveyance direction of circuit base material 12 is referred to as an X-direction, a horizontal direction perpendicular to that direction is referred to as a Y-direction, and a vertical direction is referred to as a Z-direction. That is, a widthwise direction of component mounter 10 is the X-direction, and a front-rear direction thereof is the Y-direction.

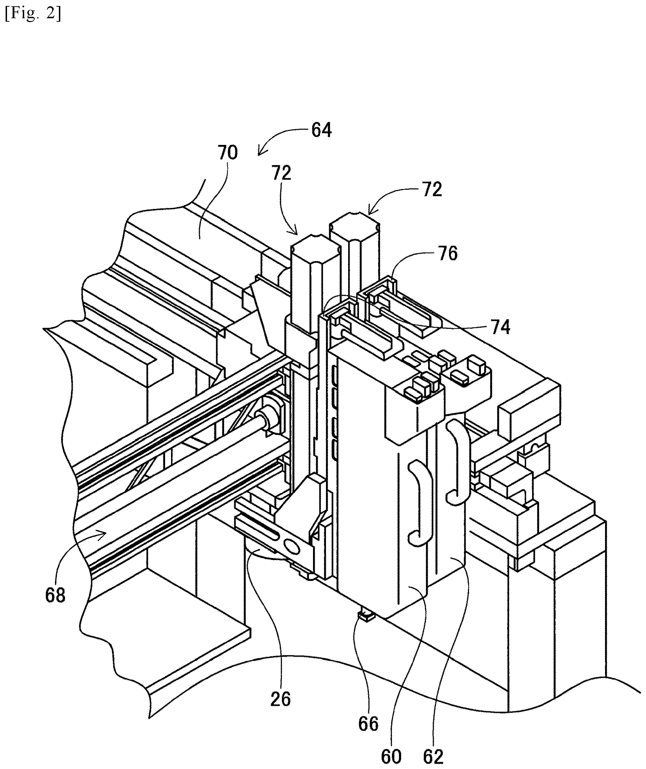

Component mounting device 24 is disposed on beam 42 and includes two work heads 60, 62 and work head moving device 64. Work heads 60, 62 each include suction nozzle (refer to Fig. 2) 66 and hold a component using suction nozzle 66. In addition, work head moving device 64 includes X-direction moving device 68, Y-direction moving device 70, and Z-direction moving device 72. Then, two work heads 60, 62 are integrally moved to any position on frame 40 by X-direction moving device 68 and Y-direction moving device 70. Additionally, as shown in Fig. 2, work heads 60, 62 are detachably positioned on sliders 74, 76, respectively, through a one-touch action by an operator without using any tool to thereby be detachably attached thereto, and Z-direction moving device 72 moves sliders 74, 76 in an up-down direction individually and separately. That is, work heads 60, 62 are moved in the up-down direction individually and separately by Z-direction moving device 72.

Imaging device 26 is attached to slider 74 in such a state that imaging device 26 is directed downwards and is moved in the X-direction, Y-direction, and Z-direction together with work head 60. As a result, imaging device 26 images any position on frame 40. As shown in Fig. 1, imaging device 28 is disposed between base material conveyance and holding device 22 on frame 40 and component supply device 30 in such a state that imaging device 28 is directed upwards. As a result, imaging device 28 images components held by suction nozzles 66 of work heads 60, 62.

Component supply device 30 is disposed at a first end portion of component mounting device 24 in a front-rear direction of frame 40. Component supply device 30 includes tray-type component supply device 78 and a feeder-type component supply device (not shown). Tray-type component supply device 78 is a device for supplying components in such a state that the components are placed on a tray. Feeder-type component supply device is a device for supplying components by a tape feeder (not shown), a stick feeder (not shown), a bulk component feeder device for supplying multiple components which are scattered separately, or the like.

Bulk component supply device 32 is disposed at a second end portion of component mounting device 24 in the front-rear direction of frame 40. Bulk component supply device 32 is a device for aligning multiple components which are scattered separately and supplying the multiple components in such an aligned state. That is, bulk component supply device 32 is a device for aligning multiple components which are oriented arbitrarily into a predetermined orientation and supplying the multiple components which are now aligned into the predetermined orientation. Hereinafter, the configuration of component supply device 32 will be described in detail. Examples of components which are supplied by component supply device 30 and bulk component supply device 32 include electronic circuit components, constituent components of a solar cell, constituent components of a power module, and the like. In addition, the electronic circuit components include a component with a lead, a component without a lead, and the like.

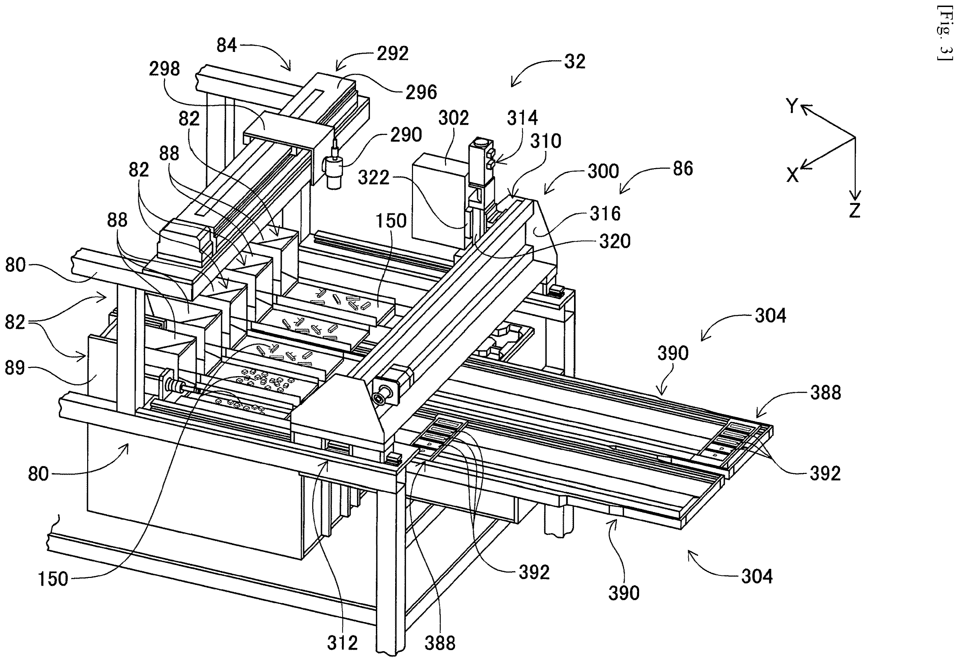

As shown in Fig. 3, bulk component supply device 32 includes main body 80, component supply units 82, two-dimensional imaging device 84, and component delivery device 86.

(a) Component Supply Unit

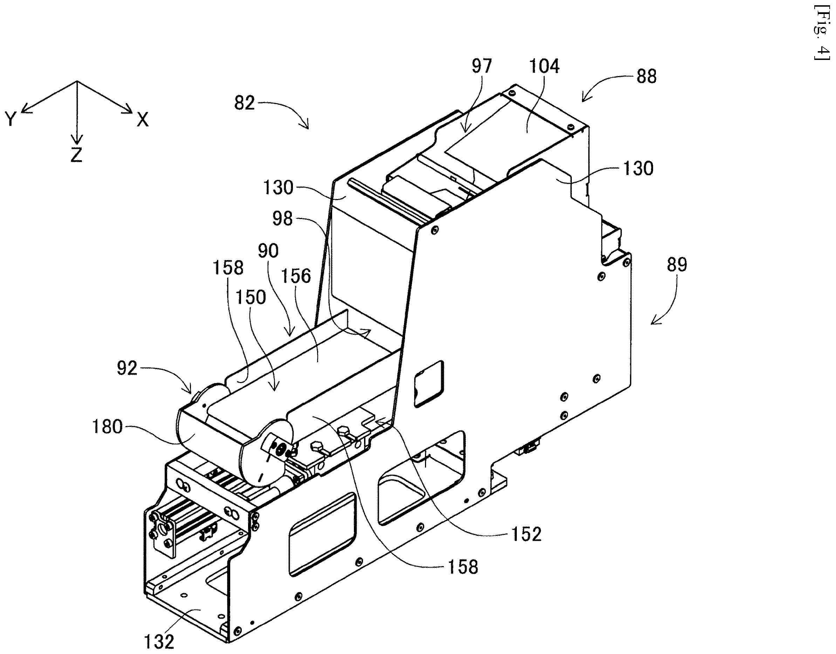

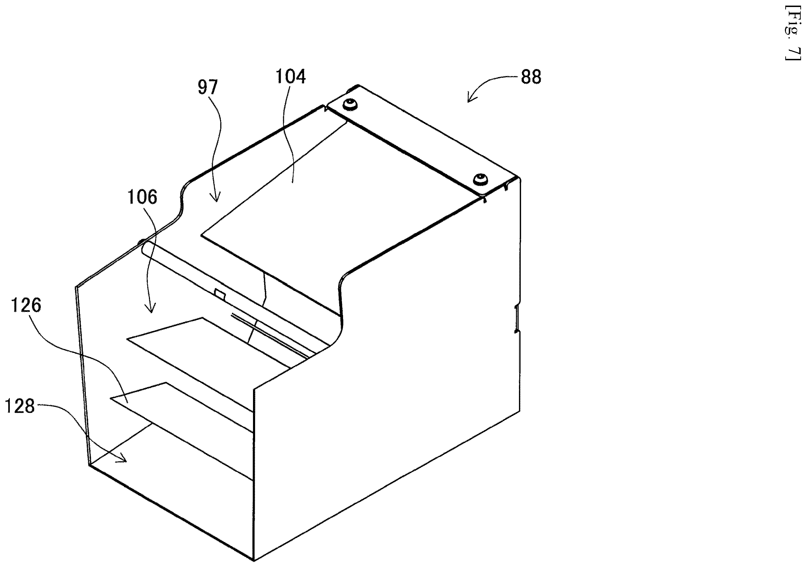

Component supply unit 82 includes component feeder (refer to Fig. 7) 88, frame 89, component scattering device (refer to Fig. 4) 90, and component return device (refer to Fig. 4) 92, and these component feeder 88, frame 89, component scattering device 90, and component return device 92 are configured as an integral unit. Component supply unit 82 is detachably positioned on main body 80 by an operator through a one-touch action without using any tool to thereby be detachably attached thereto, and five component supply units 82 are disposed side by side into a row in the X-direction in bulk component supply device 32.

As shown in Figs. 4 to 7, component feeder 88 has a generally rectangular parallelepiped box-like shape and is disposed in such a manner as to extend in the Y direction. The Y-direction will be described as a front-rear direction of component feeder 88, a direction toward an end of component supply unit 82 where component return device 92 is disposed will be described as front or forward, and a direction toward an end of component supply unit 82 where component feeder 88 is disposed will be described as rear or rearward.

Component feeder 88 is opened in an upper surface and a front surface thereof, and an opening in the upper surface is made into component loading port 97, while an opening in the front surface is made into component discharge port 98. In component feeder 88, inclined plate 104 is disposed below loading port 97. Inclined plate 104 is disposed in such a manner as to be inclined downward in a direction toward a center of component feeder 88 from a rear end face thereof.

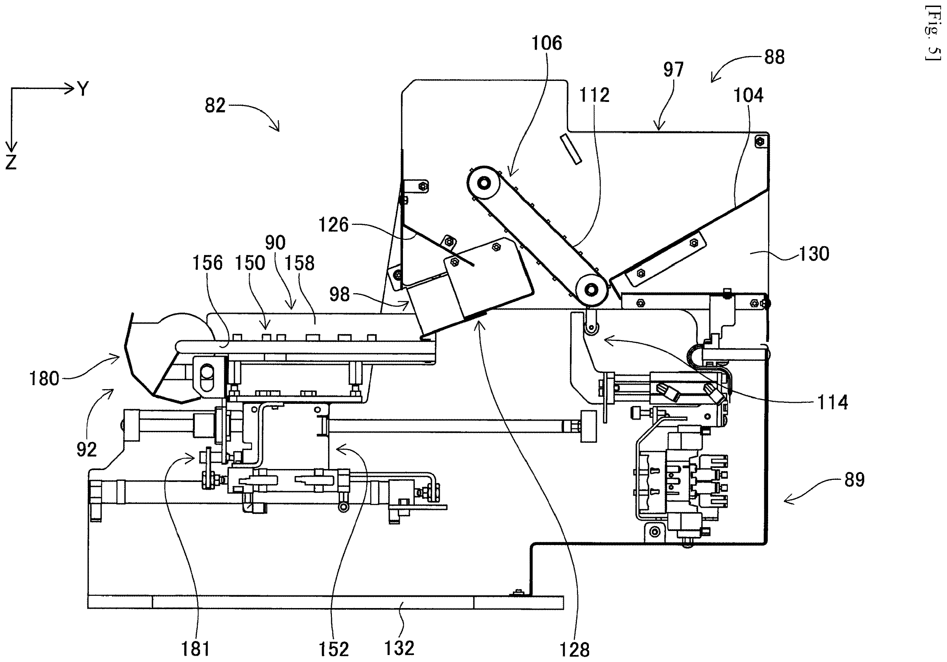

In addition, conveyor device 106 is disposed at the front of inclined plate 104, as shown in Fig. 5. Conveyor device 106 is disposed in such a manner as to be inclined upward from a front end portion of inclined plate 104 toward the front of component feeder 88. Conveyor belt 112 of conveyor device 106 is caused to rotate in a counterclockwise direction in Fig. 5 by driving electromagnetic motor (refer to Fig. 12) 116. That is, a conveyance direction of conveyor device 106 is referred to as an obliquely upward direction extending forwards from the front end portion of inclined plate 104 .

Further, inclined plate 126 is disposed below a front end portion of conveyor device 106. Inclined plate 126 is disposed in such a manner as to extend from a front end face of component feeder 88 towards below conveyor device 106, and a rear end portion of inclined plate 126 is inclined obliquely downward. Furthermore, inclined plate 128 is also disposed below inclined plate 126. Inclined plate 128 is disposed to extend from a position lying below a center portion of conveyor device 106 towards discharge port 98 of component feeder 88 in such a manner as to be inclined so that a front end portion of inclined plate 128 is positioned further downward.

In addition, as shown in Fig. 4, frame 89 is made up of pair of side frames 130 and connecting frame 132.

Pair of side frames 130 are erected in such a manner as to extend parallel to each other and in the Y-direction while facing each other. Then, connecting frame 132 is placed at lower ends of pair of side frames 130 in such a manner as to straddle a space defined therebetween, whereby pair of side frames 130 are connected together by connecting frame 132. Frame 89 functions as a housing of component supply unit 82; however, frame 89 may not function as a housing but may constitute a reinforcing member, an outer shell member, a housing, a cover, a casing, or the like of component supply unit 82. Further, a distance between pair of side frames 130 is set slightly larger than a widthwise dimension of component feeder 88, so that component feeder 88 can detachably be mounted between pair of side frames 130 through a one-touch action while being positioned therebetween. Detachable mounting through the one-touch action means that component feeder 88 is detachably mounted in position in a repeatable fashion by the operator without using any tool or the like.

Further, as shown in Figs. 4 and 5, component scattering device 90 includes component support member 150 and component support member moving device 152. Component support member 150 is made up of stage 156 and pair of side wall portions 158. Stage 156 has a generally longitudinal plate-like shape and is disposed in such a manner as to extend to the front from below component feeder 88 mounted between pair of side frames 130. Additionally, a widthwise dimension of stage 156 is set approximately the same as the distance defined between pair of side frames 130, that is, a widthwise dimension of frame 89, and a rear end portion of stage 156 is positioned between pair of side frames 130. An upper surface of stage 156 is generally horizontal and is disposed in such a state that a slight clearance is provided between a front end portion of inclined plate 128 of component feeder 88 and itself at a rear end portion thereof as shown in Fig. 5. Further, as shown in Fig. 4, pair of side wall portions 158 are individually erected along both longitudinal side portions of stage 156 in such a manner as to be fixed thereto, and upper ends of both side wall portions 158 extend further upwards than the upper surface of stage 156.

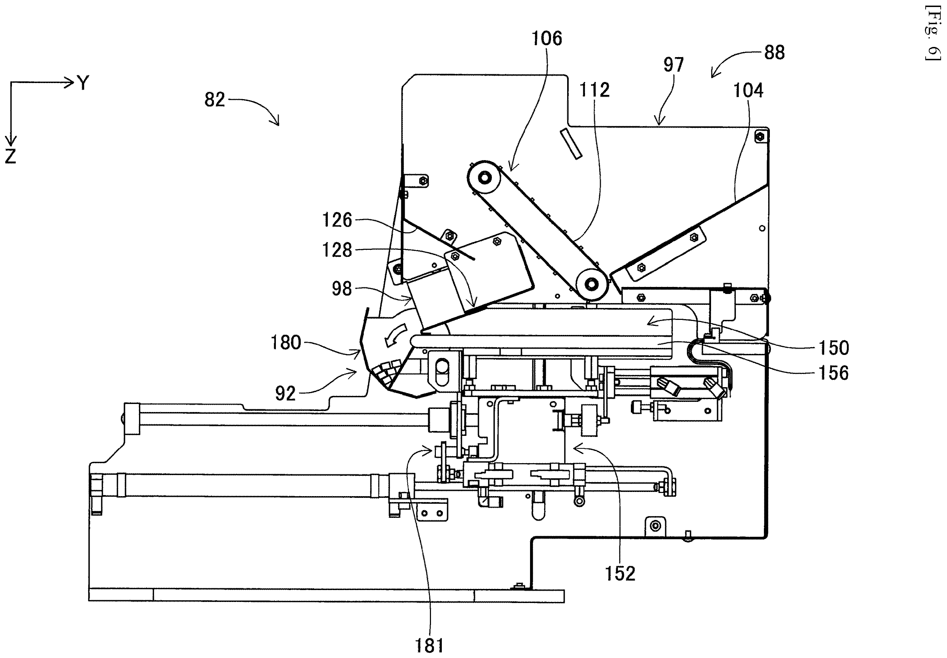

Component support member moving device 152 causes component support member 150 to slide in the Y-direction as air cylinder (refer to Fig. 12) 166 operates accordingly. As this occurs, component support member 150 moves between a retracted state (refer to Fig. 6) in which component support member 150 is retracted underneath component feeder 88 and an exposed state (refer to Fig. 5) in which component support member 150 is exposed from underneath component feeder 88.

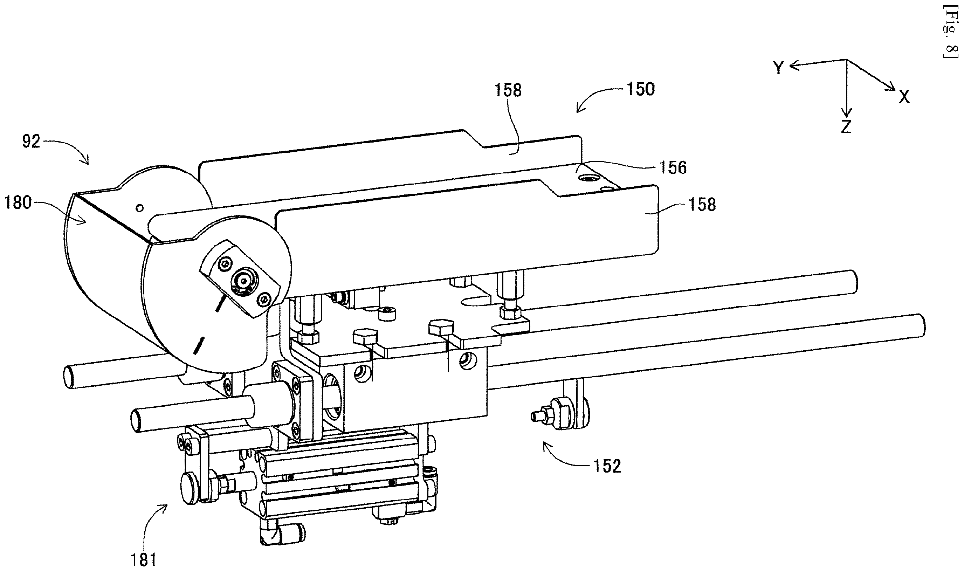

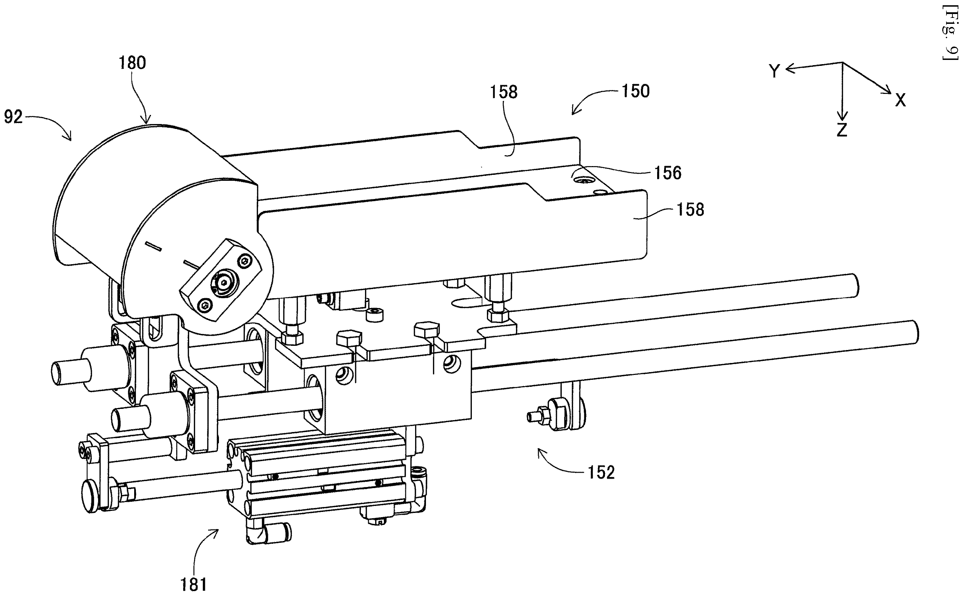

As shown in Fig. 8, component return device 92 includes component accommodating container 180 and container swing device 181. Component accommodating container 180 has a generally box-like shape and an arc-shaped bottom surface. A widthwise dimension of component accommodating container 180 is set approximately the same as the widthwise dimension of stage 156. That component accommodating container 180 is held in a swinging fashion at a front end portion of stage 156 and swings as container swing device 181 operates accordingly. When it swings, component accommodating container 180 swings between an accommodation orientation (refer to Fig. 8) in which an opening thereof is directed upwards and a return orientation (refer to Fig. 9) in which the opening is directed towards the upper surface of stage 156 of component support member 150.

(b) Two-Dimensional Imaging Device

As shown in Fig. 3, two-dimensional imaging device 84 includes camera 290 and camera moving device 292. Camera moving device 292 includes guide rail 296 and slider 298. Guide rail 296 is fixed to main body 80 above component feeders 88 in such a manner as to extend in a widthwise direction (X-direction) of bulk component supply device 32. Slider 298 is slidably attached to guide rail 296 and slides to any position as electromagnetic motor (refer to Fig. 12) 299 operates accordingly. Cameras 290 is provided one and is fixedly attached to slider 298 in such a state that camera 29 is directed downwards. Camera 290 is a three-dimensional camera which can detect height information, depth information, or the like of a three-dimensional imaging target object or a two-dimensional camera without a three-dimensional image processing device which cannot detect height information, depth information, or the like of a three-dimensional imaging target object. In addition, camera 290 does not employ a telecentric lens system in which an aperture stop is located in a focal point position of a lens but employs a general lens, that is, a lens whose angle of view is not 0 degree.

(c) Component Delivery Device

Component delivery device 86 includes, as shown in Fig. 3, component holding head moving device 300, component holding head 302, and two shuttle devices 304.

Component holding head moving device 300 includes X-direction moving device 310, Y-direction moving device 312, and Z-direction moving device 314. Y-direction moving device 312 includes Y-slider 316 which is disposed above component supply units 82 in such a manner as to extend in the X-direction, and Y-slider 316 moves to any position in the Y-direction as electromagnetic motor (refer to Fig. 12) 319 is driven accordingly. X-direction moving device 310 includes X-slider 320 which is disposed on a side surface of Y-slider 316, and X-slider 320 moves to any position in the X-direction as electromagnetic motor (refer to Fig. 12) 321 is driven accordingly. Z-direction moving device 314 includes Z-slider 322 which is disposed on a side surface of X-slider 320, and Z-slider 322 moves to any position in the Z-direction as electromagnetic motor (refer to Fig. 12) 323 is driven accordingly.

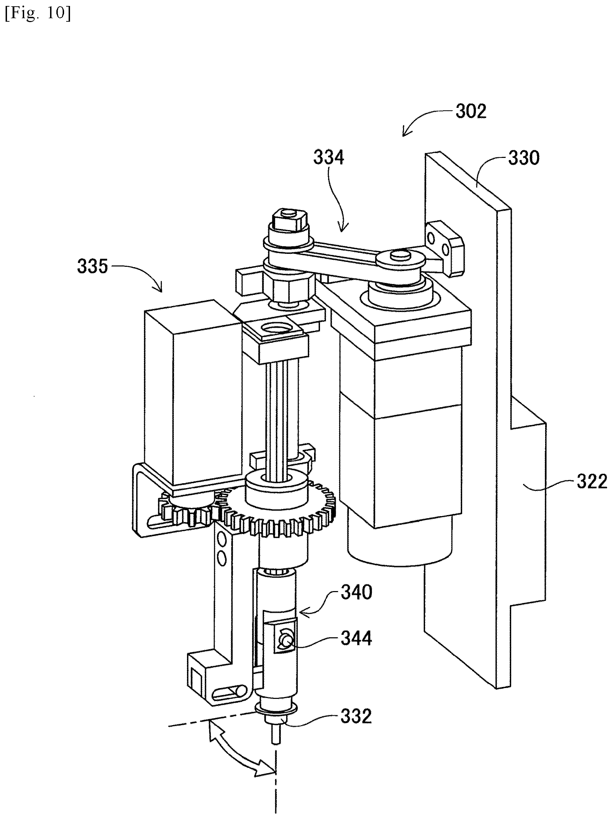

As shown in Fig. 10, component holding head 302 includes head main body 330, suction nozzle 332, nozzle pivoting device 334, and nozzle rotation device 335. Head main body 330 is formed integrally with Z-slider 322. Suction nozzle 332 is configured to hold a component and is detachably attached to a lower end portion of holder 340. Holder 340 is configured to be bendable on support shaft 344, and holder 340 is bent upwards through 90 degrees as nozzle pivoting device 334 operates accordingly. As a result, suction nozzle 332, which is attached to the lower end portion of holder 340, pivots through 90° to be positioned in a pivoted position and then stops there. That is, suction nozzle 332 pivots between a non-pivoted position and the pivoted position as nozzle pivoting device 334 operates accordingly. Of course, suction nozzle 332 can be positioned to stop at an angle position between the non-pivoted position and the pivoted position. Nozzle rotation device 335 causes suction nozzle 332 to rotate around an axis center thereof.

As shown in Fig. 3, two shuttle devices 304 each include component carrier 388 and component carrier moving device 390 and are fixed to main body 80 in such a manner as to be aligned side by side in a lateral direction along front ends of component supply units 82. Component carrier 388 includes five component receiving members 392, which are attached thereto while being aligned in a row in the lateral direction, so that components are placed individually and separately on component receiving members 392.

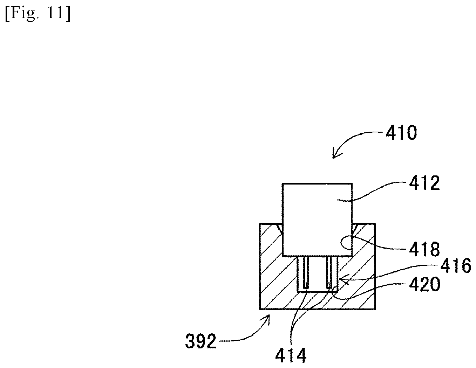

Bulk component supply device 32 can supply various types of components, and various types of component receiving members 392 are prepared so as to match shapes of those various types of components. Here, as an electronic component that is supplied by bulk component supply device 32, as shown in Fig. 11, component receiving member 392 will be described which matches lead component 410 having leads. Lead component 410 is made up of a block-shaped component main body 412 and two leads 414 protruding from a bottom surface of component main body 412.

Component receiving member 392 has formed therein component receiving recessed section 416 having a shape matching the shape of lead component 410. Component receiving recessed section 416 is a recessed section having a stepped shape and is made up of main body section receiving recessed section 418, which opens in an upper surface of component receiving member 392, and lead receiving recessed section 420, which is formed to provide an opening in a bottom surface of main body section receiving recessed section 418. Then, lead component 410 is inserted inside component receiving recessed section 416 while being oriented in such a manner that leads 414 are directed downwards. As a result, lead component 410 is placed inside component receiving recessed section 416 in such a state that leads 414 are inserted into lead receiving recessed section 420 and component main body 412 is inserted into main body section receiving recessed section 418.

Further, as shown in Fig. 3, component carrier moving device 390 is a plate-shaped longitudinal member and is disposed at the front ends of component supply units 82 in such a manner as to extend in the front-rear direction. Component carrier 388 is disposed on an upper surface of component carrier moving device 390 in such a manner as to slide in the front-rear direction, so that component carrier 388 slides to an arbitrary position in the front-rear direction as electromagnetic motor (refer to Fig. 12) 430 is driven accordingly. When component carrier 388 slides in a direction in which component carrier 388 moves towards component supply units 82, component carrier 388 slides as far as a component receiving position which is located within a moving range of component holding head 302 which is moved by component holding head moving device 300. On the other hand, when component carrier 388 slides in a direction in which component carrier 388 moves away from component supply units 82, component carrier 388 slides to a component supply position which is located within moving ranges of work heads 60, 62 which are moved by work head moving device 64.

Control device 34 includes, as shown in Fig. 12, integrated control device 450, multiple individual control devices (only one is shown in the figure) 452, and image processing device 454. Integrated control device 450 is made up mainly of a computer and is connected to base material conveyance and holding device 22, component mounting device 24, imaging device 26, imaging device 28, component supply device 30, and bulk component supply device 32. As a result, integrated control device 450 integrally controls base material conveyance and holding device 22, component mounting device 24, imaging device 26, imaging device 28, component supply device 30, and bulk component supply device 32. Multiple individual control devices 452 are each made up mainly of a computer and are provided individually and separately for base material conveyance and holding device 22, component mounting device 24, imaging device 26, imaging device 28, component supply device 30, and bulk component supply device 32 (in the figure, only individual control device 452 for bulk component supply device 32 is shown).

Individual control device 452 of bulk component supply device 32 is connected to component feeder 88, component scattering device 90, component return device 92, camera moving device 292, component holding head moving device 300, component holding head 302, and shuttle devices 304. As a result, individual control device 452 of bulk component supply device 32 controls component feeder 88, component scattering device 90, component return device 92, camera moving device 292, component holding head moving device 300, component holding head 302, and shuttle devices 304. Image processing device 454 is connected to two-dimensional imaging device 84 to process image data captured by two-dimensional imaging device 84. That image processing device 454 is connected to individual control device 452 of bulk component supply device 32. As a result, individual control device 452 of bulk component supply device 32 obtains two-dimensional image data captured by two-dimensional imaging device 84.

(B) Operation of Component Mounter

With the configuration that has been described heretofore, component mounter 10 executes a component mounting operation on circuit base material 12 which is held by base material conveyance and holding device 22. Specifically speaking, circuit base material 12 is conveyed to a work position by base material conveyance and holding device 22 and is fixedly held by clamp device 52 in that work position. Next, imaging device 26 moves to a position lying above circuit base material 12, which is now fixedly held in position, and images circuit base material 12. As a result, information on an error in the holding position of circuit base material 12 can be obtained. Component supply device 30 or bulk component supply device 32 supplies a component in a predetermined supply position. A supply of a component by bulk component supply device 32 will be described in detail later on. Then, either of work heads 60, 62 moves to a position lying above the component supply position to hold a component with suction nozzle 66. Subsequently, work head 60 or 62 which holds the component moves to a position lying above imaging device 28, whereby the component held by suction nozzle 66 of work head 60 or 62 is imaged by imaging device 28. As a result, information on an error in the holding position of the component can be obtained. Then, work head 60 or 62 which holds the component moves to a position lying above circuit base material 12 to mount the component which work head 60 or 62 holds on circuit base material 12 by correcting an error in the holding position of circuit base material 12 and the error in the holding position of the component.

(C) Operation of Bulk Component Supply Device

In bulk component supply device 32, components 410 of one type are loaded into loading port 97 of one component feeder 88 by the operator, and these lead components 410 so loaded are supplied in such a state that they are placed on component receiving member 392 of component carrier 388 as component supply unit 82 and component delivery device 86 operate accordingly.

Specifically speaking, the operator loads lead components 410 of one type into loading port 97 opened in the upper surface of each component feeder 88. As this occurs, component support member 150 is caused to move to the position lying below component feeder 88 in question as a result of operation of component support member moving device 152 to thereby stay in the retracted state (refer to Fig. 6). With component support member 150 staying in the retracted state, component accommodating container 180, which is disposed at the front end portion of component support member 150, is positioned at the front of component feeder 88, assuming an orientation (an accommodating orientation) in which the opening of component accommodating container 180 is directed upwards.

Lead components 410 loaded from loading port of inlet 97 of component feeder 88 fall on inclined plate 104 of component feeder 88 and roll down to a lower end of inclined plate 104 at the front thereof. Then, lead components 410, which have rolled down to the lower end at the front of inclined plate 104, are accumulated between the lower end of inclined plate 104 at the front thereof and a lower end of conveyor device 106 at the rear thereof. Then, conveyor belt 112 of conveyor device 106 circulates counterclockwise, as seen in Fig. 6, as conveyor device 106 operates accordingly. As this occurs, lead components 410, which are accumulated between inclined plate 104 and conveyor belt 112, are then conveyed obliquely upwards by conveyor belt 112.

Then, Lead components 410, which are conveyed by conveyor belt 112, fall on inclined plate 126 from an upper end of conveyor device 106 at the front thereof. Lead components 410, which have fallen on inclined plate 126, then roll down on inclined plate 126 to the rear to fall onto inclined plate 128. Lead components 410,which have fallen on inclined plate 128, then roll down to the front to be discharged from discharge port 98 of component feeder 88 at the front thereof.

As a result, lead components 410, which have been discharged from discharge port 98 of component feeder 88, are accommodated inside component accommodating container 180. Then, when a predetermined amount of lead components 410 is discharged from component feeder 88, that is, when conveyor device 106 operates by a certain amount, conveyor device 106 stops. Next, component support member 150 moves from the retracted state towards the front as component support member moving device 152 operates accordingly.

Then, container swinging device 181 of component return device 92 operates at a timing when component support member 150 moves a predetermined amount from the retracted state towards the front where component support member 150 is put in an exposed state, whereby component accommodating container 180 starts swinging. As a result, the orientation of component accommodating container 180 vigorously changes from the orientation(accommodating orientation) in which the opening is directed upwards to an orientation (returned orientation) in which the opening is directed towards stage 156. As this occurs, lead components 410, which are accommodated in component accommodating container 180, are vigorously discharged towards stage 156. As a result, lead components 410 of one type are scattered from component accommodating container 180 onto stage 156. In this case, for scattering of lead components 410, situations are considered in which lead components 410 are scattered while overlapping one another and in which lead components 410 are scattered separately from one another without overlapping one another.

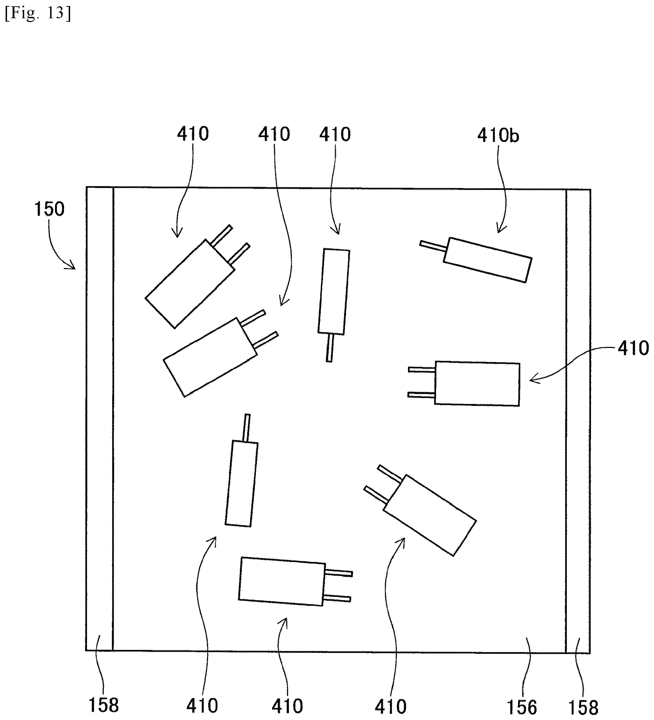

When lead components 410 are scattered from component feeder 88 onto stage 156 of component support member 150 in accordance with the procedure described above, camera 290 of two-dimensional imaging device 84 moves to a position lying above component support member 150 as a result of operation of camera moving device 292 and then stops in an imaging position to image lead components 410. As a result, as shown in Fig. 13, two-dimensional image data of each of multiple lead components 410 which are scattered on the upper surface of component support member 150 is obtained. Then, information on positions of multiple lead components 410 which are scattered on the upper surface of component support member 150, orientations of those lead components 410 on component support member 150, and the like is calculated based on the two-dimensional image data so obtained.

Then, component holding head 302 is caused to move to a position lying above one lead component 410 based on the information on the position and orientation thereof so calculated and the like as component holding head moving device 300 operates accordingly, whereby lead component 410 in question is picked up and held by suction nozzle 332. When a lead component is picked up and held by suction nozzle 332, suction nozzle 332 is positioned in the non-pivoted position with a suction port thereof directed downwards, and a pickup surface, which constitutes the suction port, stays parallel to a horizontal plane.

Then, component holding head 302 moves upwards away from component carrier 388 after lead component 410 is held by suction nozzle 332. As this occurs, component carrier 388 is then moved to the component receiving position as a result of operation of component carrier moving device 390. When component holding head 302 moves upwards away from component carrier 388, suction nozzle 332 is pivoted to the pivoted position. Suction nozzle 332 is caused to revolve by nozzle rotation device 335 which operates accordingly so that leads 414 of lead component 410 held by suction nozzle 332, which is now positioned in the pivoted position, are directed downwards in a vertical direction.

When component holding head 302 moves upwards to stay above component carrier 388, lead component 410 whose leads 414 are directed downwards in the vertical direction are inserted into component receiving recessed section 416 of component receiving member 392. As a result, as shown in Fig. 11, lead component 410 is placed in component receiving member 392 in such a state that leads 414 are directed downwards in the vertical direction.

Then, when lead component 410 is placed in component receiving member 392, component carrier 388 moves to the component supply position as component carrier moving device 390 operates accordingly. Since component carrier 388, which has moved to the component supply position, is now positioned within the moving ranges of work heads 60, 62, in bulk component supply device 32, lead component 410 is supplied to component mounter 10 in this position. In this way, in bulk component supply device 32, lead component 410 is supplied while being placed in component receiving member 392 in such a state that leads 414 are directed downwards and the upper surface, which faces the bottom surface to which leads 414 are connected, is directed upwards. As a result, suction nozzles 66 of work heads 60, 62 can suitably hold corresponding lead components 410.

As described above, with bulk component supply device 32, components of one type are scattered from component feeder 88 onto stage 156, and the components so scattered on stage 156 are imaged by camera 290. Then, positions and orientations of those components are calculated based on the image data so captured, and the components scattered on stage 156 are held by component holding head 302 by making use of the positions and orientations so calculated. However, camera 290 used to image the components scattered on stage 156 is the two-dimensional camera, and further, no telecentric lens is used in camera 290. Therefore, when calculating positions and orientations of the components based on the image data so captured, positions and orientations of the components are calculated in consideration of a height dimension of the component.

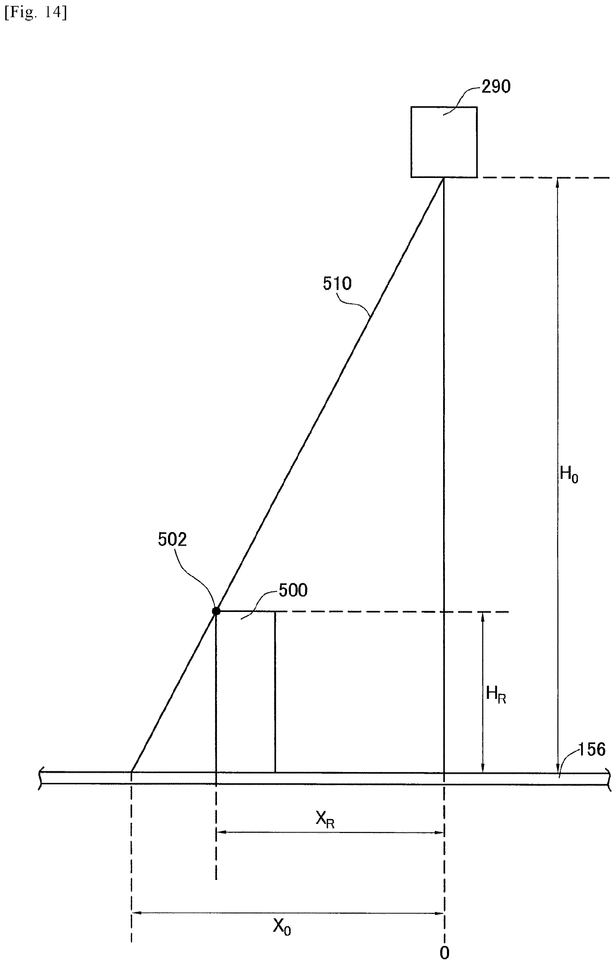

To describe this in detail, when one component on stage 156 is imaged by camera 290, camera 290 performs fixed-point imaging. Specifically speaking, for example, camera 290 images the upper surface of stage 156 once in such a state that camera 290 is fixed at a center of stage 156 and at a predetermined height above stage 156. As a result, in the case that components are scattered in positions other than the center of stage 156, a position of a component which is calculated based on image data captured for one of those scattered components (hereinafter, referred to as an "imaged component position") differs from a position where the component is actually placed (hereinafter, referred to as an "actual component position") To describe this in detail, a case is taken into consideration in which as shown in Fig. 14, assuming that a position on the stage lying directly below camera 290 is referred to as an origin (0), component 500 having height dimension HR is placed in a position lying away from the origin, and in four corner portions of an upper end face of component 500 in question, one corner portion 502 is located a distance of $X_R$ away from the origin. In this case, in an image based on image data captured by camera 290, corner portion 502 of component 500 is positioned a distance of $X_O$ away from the origin. This is because corner portion 502 of component 500, which is located the distance of $X_R$ away from the origin, and an upper surface of stage 156 which is located the distance of $X_O$ away from the origin are located on one principal ray 510 of camera 290. As a result, when a position for corner portion 502 of component 500 is calculated based on the image data captured by camera 290, corner portion 502 is calculated as being located the distance of $X_O$ away from the origin. Thus, actual component position $X_R$ and imaged component position $X_O$ of corner portion 502 of component 500 differ from each other.

Then, an actual component position of corner portion 502 is calculated by making use of height dimension $H_R$ of component 500 and height dimension $H_O$ at which camera 290 is disposed. That is, the following expression is established between actual component position $X_R$ and imaged component position $X_0$.

$$X_0 : X_R = H_0 : (H_0 - H_R)$$

As a result, actual component position $X_R$ is calculated according to the following expression.

$$X_R = \{ X_0 \times (H_0 - H_R) \} / H_0$$

However, if corner portion 502 lies directly below camera 290, that is, at the origin (O), the actual component position and the imaged component position will coincide with each other, irrespective of the height dimension of the component.

When actual component position $X_R$ of corner portion 502 of component 500 is calculated in the way described above, actual component positions $X_R$ of three remaining corner portions 502 of component 500 are also calculated using the same method. Then, a holding position of component 500 is calculated based on actual component positions $X_R$ of the four corner portions of component 500. For example, in the case that a center of the upper end face of component 500 constitutes an expected holding position, a center position of actual component positions $X_R$ of the four corner portions is calculated as a component holding position.

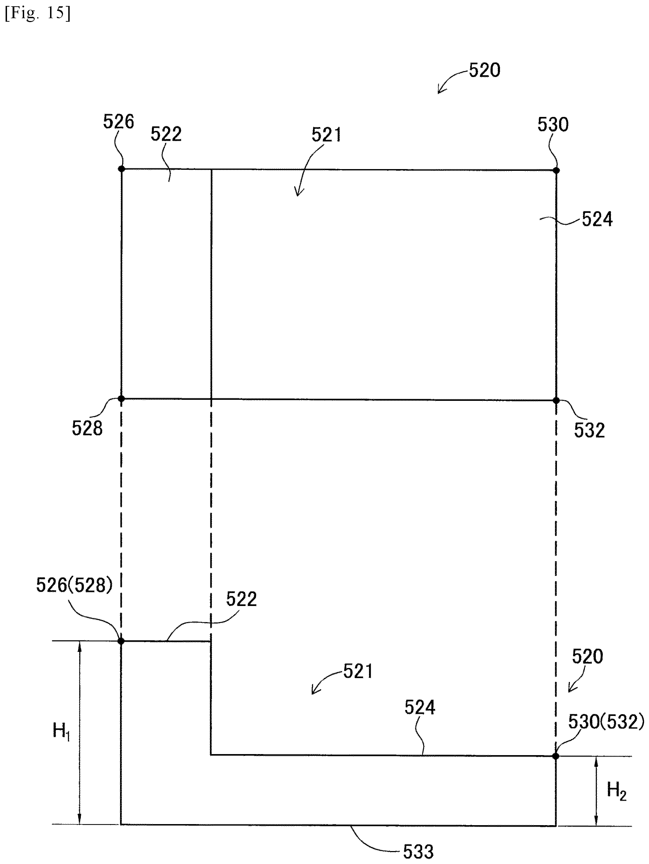

However, the component holding position calculated by the method described above is effective only in a case in which when the height dimension of the upper end face of the component is uniform, and hence, in the case that a height dimension of an upper end face of a component is not uniform, there may be a case in which a component holding position calculated deviates from an expected holding position of the component. To describe this in detail, with component 520 shown in Fig. 15, a first surface of component 520 is made into a flat surface, whereas a second surface of component 520 is made into a stepped surface 521. That stepped surface 521 is made up of projecting section 522, which is located at a first end portion in a longitudinal direction, and recessed section 524, which is located at a second end portion in the longitudinal direction. Then, a height dimension of projecting section 522 is referred to as $H_1$, and a height dimension of recessed section 524 is referred to as $H_2$.

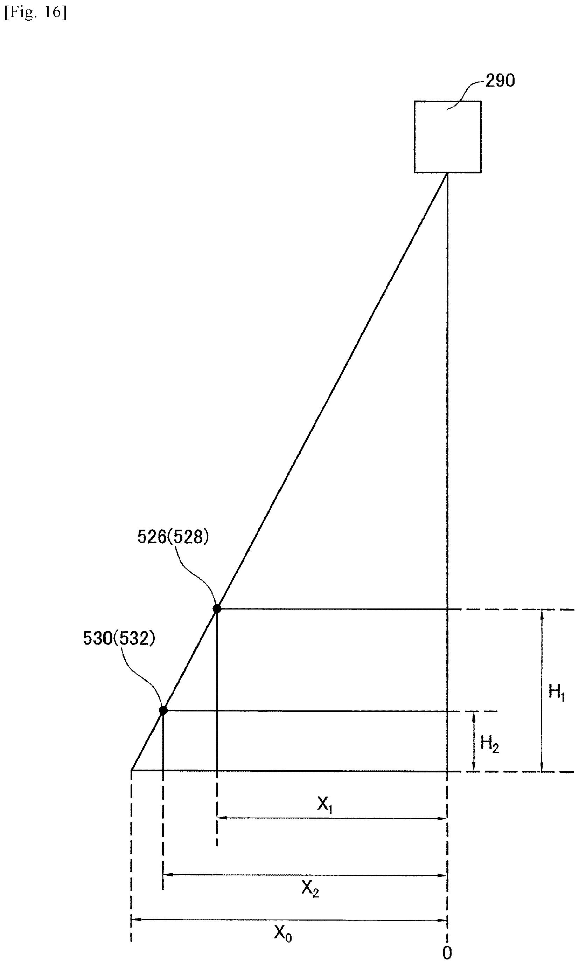

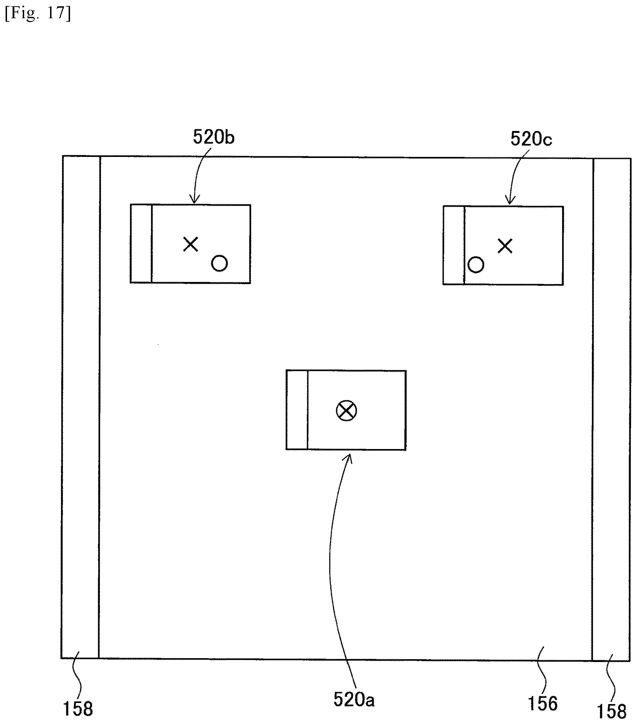

Thus, component 520 has the two height dimensions (Hi, $H_2$); however, since a component holding position is calculated using one height dimension in the method described above, a holding position of component 520 is experimentally calculated using, for example, the height dimension (Hi) of projecting section 522. Specifically speaking, in four corner portions 526, 528, 530, 532 of an upper end face of component 520, actual component positions of corner portions 526, 528 which are positioned on projecting section 522 are calculated using the height dimension (Hi). For this calculation, since the height dimension of corner portions 526, 528 is $H_1$, actual component positions of corner portions 526, 528 can be calculated suitably by use of the height dimension (Hi). In addition, in four corner portions 526, 528, 530, 532 of the upper end face of component 520, actual component positions of corner portions 530, 532 which are positioned on recessed section 524 are calculated using the height dimension (Hi). For this calculation, since the height dimension of corner portions 530, 532 is $H_2$, actual component positions of corner portions 530, 532 cannot suitably be calculated by use of the height dimension (Hi). That is, as shown in Fig. 16, when positions of corner portions 530, 532 which are positioned a distance of $X_2$ away from the origin are calculated by use of the height dimension (Hi), actual component positions of corner portions 530, 532 are calculated as being positioned $X_1$, which is shorter than $X_2$, away from the origin, although the actual component positions of corner portions 530, 532 are positioned $X_2$ away from the origin. Then, when a component holding position of component 520 is calculated by use of the positions of corner portions 530. 532 so calculated, as shown in Fig. 17, a component holding position (denoted by mark o) calculated based on captured image data constitutes a position which differs from an expected holding position (denoted by mark x) . However, since component 520a is positioned directly below camera 290, and an actual component position and an imaged component position of component 520a coincide with each other, irrespective of the height dimension of the component, a calculated component holding position (denoted by mark o) and an expected holding position (denoted by mark x) coincide with each other. On the other hand, with components 520b, 520c, components 520b, 520c deviate from a position lying directly below camera 290 on which an optical axis ray of camera 290 falls, and actual component positions of corner portions 530, 532 are calculated as being positioned $X_1$, which is shorter than $X_2$, away from the origin, although the actual component positions of corner portions 530, 532 are positioned $X_2$ away from the origin. As a result, calculated component holding positions (denoted by mark o) of components 520b, 520c deviate from expected holding positions (denoted by mark x), which are positions suitable for holding the components, towards positions lying closer to the position lying directly below camera 290, that is, closer to component 520a.

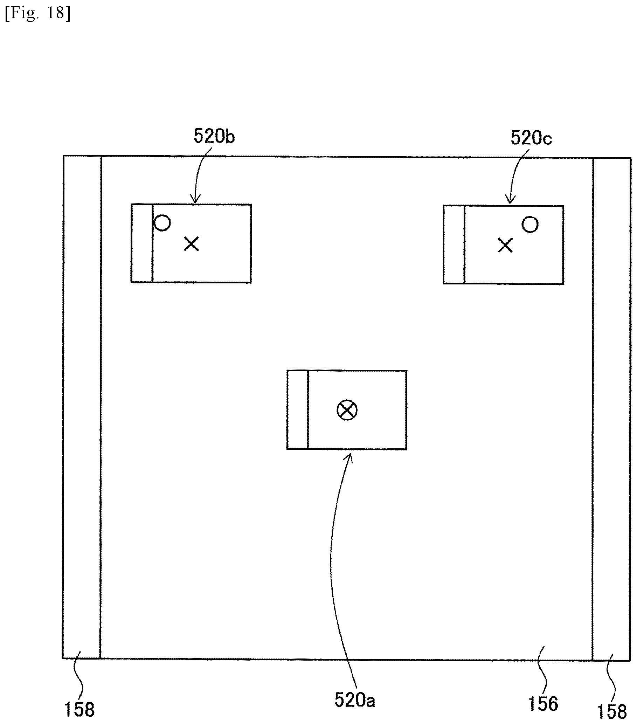

In addition, a holding position of component 520 is experimentally calculated by use of, for example, the height dimension ($H_2$) of recessed section 524. Specifically speaking, in four corner portions 526, 528, 530, 532 of the upper end face of component 520, actual component positions of corner portions 530, 532 which are positioned on recessed section 524 are calculated by use of the height dimension ($H_2$). For this calculation, since the height dimension of corner portions 530, 532 is $H_2$, actual component positions of corner portions 530, 532 can suitably be calculated by use of the height dimension ($H_2$). In addition, in four corner portions 526, 528, 530, 532 of the upper end face of component 520, actual component positions of corner portions 526, 528 which are positioned on projecting section 522 are calculated by use of the height dimension ($H_2$). For this calculation, since the height dimension of corner portions 526, 528 is $H_1$, actual component positions of corner portions 526, 528 cannot suitably be calculated by use of the height dimension (Hz). That is, as shown in Fig. 16, when positions of corner portions 526, 528 which are positioned the distance of $X_1$ away from the origin are calculated by use of the height dimension ($H_2$), actual component positions of corner portions 526, 528 are calculated as being positioned $X_2$, which is longer than $X_1$, away from the origin, although the actual component positions of corner portions 526, 528 are positioned $X_1$ away from the origin. Then, when a component holding position is calculated by use of the positions of corner portions 526, 528 so calculated, a calculated component holding position (denoted by mark o) constitutes a position which differs from an expected holding position (denoted by mark x), as shown in Fig 18. However, since component 520a is positioned directly below camera 290, and an actual component position and an imaged component position of component 520a coincide with each other, irrespective of the height dimension of the component, a calculated component holding position (denoted by mark o) and an expected holding position (denoted by mark x) coincide with each other. On the other hand, with components 520b, 520c, components 520b, 520c deviate from a position lying directly below camera 290, and actual component positions of corner portions 526, 528 are calculated as being positioned $X_2$, which is longer than $X_1$, away from the origin, although the actual component positions of corner portions 526, 528 are positioned $X_1$ away from the origin. As a result, calculated component holding positions (denoted by mark o) of components 520b, 520c deviate from expected holding positions (denoted by mark x) towards positions lying farther away from the position lying directly below camera 290, that is, farther away from component 520a.

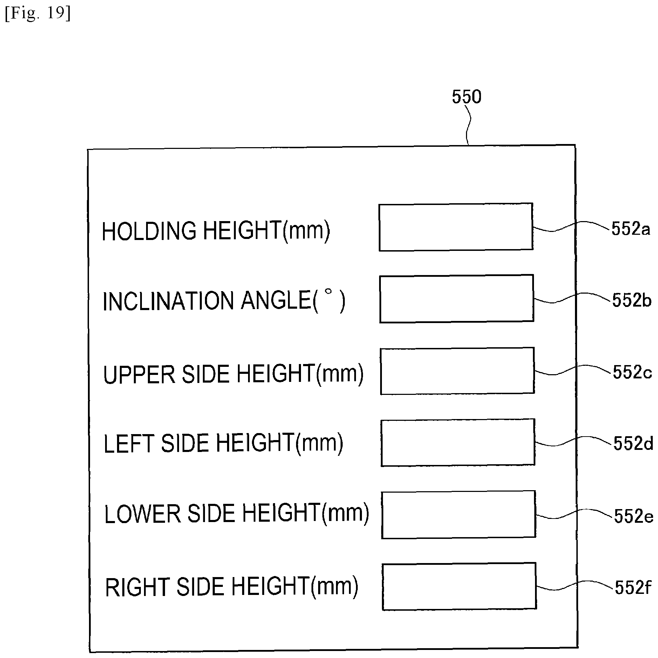

As described above, when the calculated component holding positions (denoted by mark o) deviate from the expected holding positions (denoted by mark x) of the components, the components cannot suitably be held. As a result, with bulk component supply device 32, multiple different height dimensions of a holding target component are inputted in consideration of the fact that height dimensions of an upper end face of the component are different from each other, and a component holding position is calculated by making use of the multiple height dimensions. Specifically speaking, in a program creation device (not illustrated) of a program for controlling the operation of component mounter 10, six input box areas 552a to 552f are displayed on input screen 550, as shown in Fig. 19. Input box area 552a is a box area into which a holding height is inputted, and a holding height of a component at which the component is held by component holding head 302 is inputted. For example, with component (refer to Fig. 15) 520, since the upper surface of recessed section 524 constitutes a holding position where component holding head 302 holds component 520, height dimension H2 of recessed section 524 is inputted to input box area 552a. Input box area 552b is a box area into which an inclination angle of the holding surface is inputted, and an inclination angle of the holding surface resulting when component holding head 302 holds a component is inputted. For example, in the case of component 520 (refer to Fig. 15), since the upper surface of recessed section 524 constitutes a holding surface where component holding head 302 holds component 520, and the upper surface of recessed section 524 constitutes a horizontal plane, 0 is inputted into input box area 552b.

Input box areas 552c to 552f are box areas into which height dimensions of four sides of an upper end face of a component are inputted. For example, in the case of component 520 (refer to Fig. 15), height dimension $H_1$ of a side defined by only projecting section 522, that is, a side which includes corner portion 526 and corner portion 528 is inputted to input box area 552c. In addition, height dimension $H_2$ of a side defined by only recessed section 524, that is, a side including corner portion 530 and corner portion 532 is inputted to input box area 552e. Then, height dimensions of sides defined by projecting section 522 and recessed section 524, that is, a side including corner portion 526 and corner portion 530 and a side including corner portion 528 and corner portion 532 are inputted to input box area 552d and input box area 552f. However, the sides defined by projecting section 522 and recessed section 524 are formed into a stepped shape, and a height dimension of a higher portion of the step-shaped side is $H_1$, while a height dimension of a lower portion of the step-shaped side is $H_2$. Then, in those step-shaped sides, height dimensions of portions which occupy a larger area are inputted into input box area 552d and input box area 552f. That is, as can be seen from Fig. 15, in the sides defined by projecting section 522 and recessed section 524, since the area of the portion defined by recessed section 524 is large, height dimension $H_2$ is inputted into input box area 552d and input box area 552f.

A holding operation of components 520 which are scattered on stage 156 is executed by making use of the holding height of component 520, the inclination angle of the holding surface, and the height dimensions of the four sides of stepped surface 521 of component 520 which are inputted into input screen 550 for storage. To describe this in detail, actual component positions of individual corner portions 526, 528, 530, 532 of component 520 are calculated based on image data of component 520 on the stage which is captured by camera 290 and the height dimensions of the four sides of stepped surface 521 of component 520 which are inputted from input screen 550. That is, imaged component positions $X_O$ of corner portions 526, 528, 530, 532 are calculated based on the image data so captured. Then, actual component positions $X_R$ of corner portions 526, 528, 530, 532 are calculated based on the imaged component positions so calculated and the height dimensions of the four sides which are inputted from input screen 550.

Specifically speaking, average value $H_{av}$ of the height dimensions of the four sides which are inputted into input screen 550 is calculated. That is, in the case of component 520, average value $H_{av}$ $(=(H_1+3H_2)/4)$ of the height dimensions of the four sides is calculated. Then, using average value $H_{av}$ of the height dimensions of the four sides so calculated as the height dimension of component 520, actual component positions $X_R$ of individual corner portions 526, 528, 530, 532 of component 520 are calculated by use of the expression described before. That is, actual component positions $X_R$ are calculated in accordance with the following expression.

$$X_R = \{X_0 \times (H_0 - H_{av})\}/H_0$$

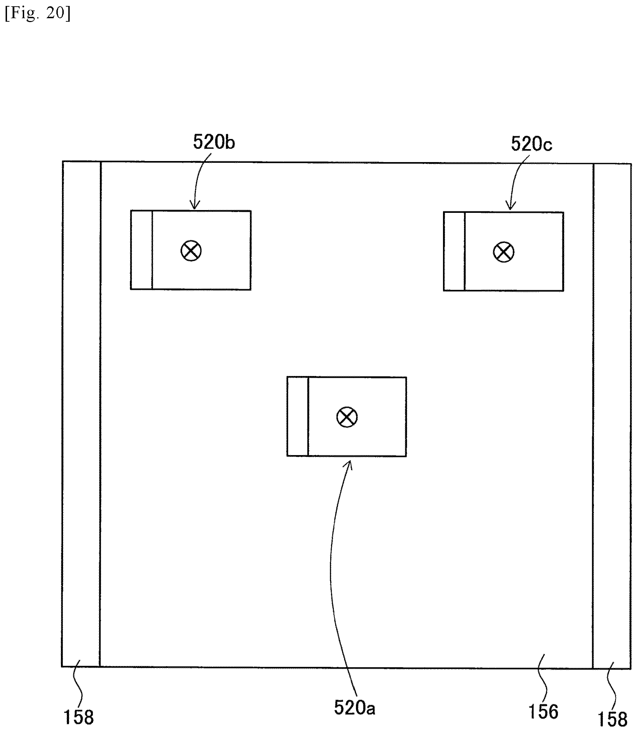

Then, when actual component positions $X_R$ of four corner portions 526, 528, 530, 532 of component 520 are calculated, a center position of actual component positions $X_R$ of four corner portions 526, 528, 530, 532 so calculated is calculated as a component holding position of component 520. Then, component holding head 302 is caused to move to a position lying above the calculated component holding position as component holding head moving device 300 operates accordingly. In addition, in component holding head 302, the pivot angle of suction nozzle 332 is controlled so as to cause suction nozzle 332 to stay at right angles to the inclination angle of the holding surface which is inputted into input screen 550 as nozzle pivoting device 334 operates accordingly. Then, component holding head 302 descends as component holding head moving device 300 operates accordingly, and component 520 is held by suction nozzle 332 at the holding height which is inputted into input screen 550. As described above, when a component holding position of component 520 is calculated using average value $H_{av}$ of the height dimensions of the four sides as the height dimension of component 520, as shown in Fig. 20, the component holding position (denoted by mark o) so calculated and an expected holding position (denoted by mark x) coincide with each other. That is, actual dimensions of components which are scattered in predetermined positions on the stage coincide with the dimensions of the components which are imaged and recognized. In other words, the component holding head can suitably hold a target component based on the shapes, positions, and orientations of the components which are scattered on the stage. As a result, a suitable component holding operation can be secured. It is desirable that the component holding position of component 520 constitutes a position of center of gravity of component 520 when component 520 is held by the holding tool.

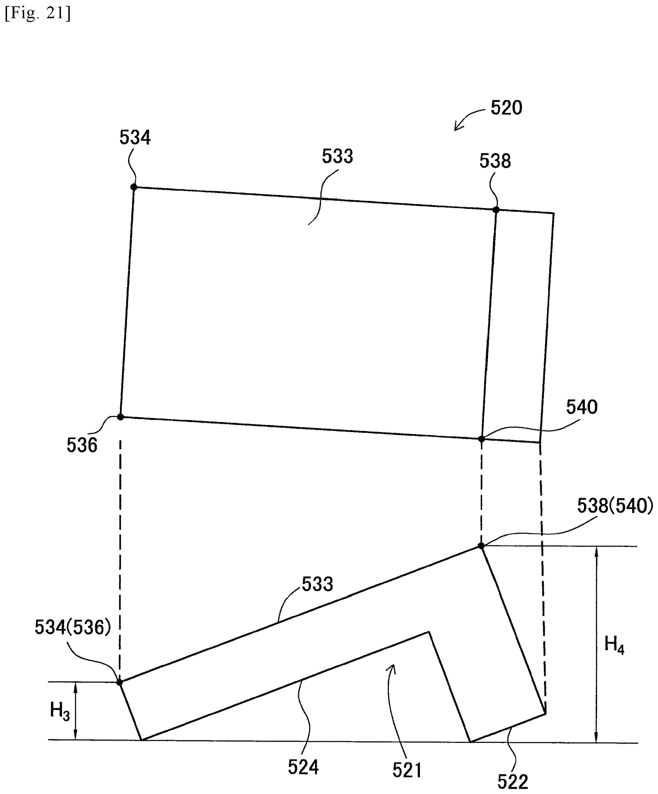

Component 520 is held by component holding head 302 while component 520 is oriented in such a manner that stepped surface 521 is directed upwards as shown in Fig. 15; however, component 520 is held by component holding head 302 while component 520 is oriented, in addition to that orientation described above, in such a manner that flat surface 533, which is opposite to stepped surface 521, is directed upwards as shown in Fig. 21. To make this happen, height dimensions of four sides of component 520, which is now oriented in such a manner that flat surface 533 is directed upwards, are inputted on input screen 550.

Specifically speaking, with component 520 oriented in such a manner that flat surface 533 is directed upwards, flat surface 533 is inclined. In this case, corner portions 534, 536 of flat surface 533 positioned above recessed section 524 of stepped surface 521 constitute a lowest position of flat surface 533, and height dimensions of corner portions 534, 536 are referred to as $H_3$. On the other hand, corner portions 538, 540 of flat surface 533 positioned above projecting section 522 of stepped surface 521 constitute a highest position of flat surface 533, and height dimensions of corner portions 538, 540 are referred to as $H_4$.

Thus, for component 520 which is oriented in such a manner that flat surface 533 is directed upwards, height dimension $H_3$ of a side including corner portion 534 and corner portion 536 of flat surface 533 is inputted into input box area 552c on input screen 550. In addition, height dimension $H_4$ of a side including corner portion 538 and corner portion 540 of flat surface 533 is inputted into input box area 552e. Height dimensions of a side including corner portion 534 and corner portion 538 and a side including corner portion 536 and corner portion 540 of flat surface 533 are inputted into input box area 552d and input box area 552f, respectively. However, the side including corner portion 534 and corner portion 538 and the side including corner portion 536 and corner portion 540 are inclined, and the height dimension of the lowest portion of the side is $H_3$, while the height dimension of the highest portion of the side is $H_4$. Then, average height dimensions of those sides are inputted into input box area 552d and input box area 552f, respectively. As a result, height dimension $(H_3+H_4)/2$ is inputted into input box area 552d and input box area 552f as the height dimensions of the side including corner portion 534 and corner portion 538 and the side including corner portion 536 and corner portion 540.

With component 520 which is oriented in such a manner that flat surface 533 is directed upwards, a center of flat surface 533 constitutes a holding position of component 520. As a result, a mean height dimension between the side including corner portion 534 and corner portion 536 and the side including corner portion 538 and corner portion 540, that is, height dimension $(H_3+H_4)/2$ is inputted into input box area 552a on input screen 550 as a holding height of component 520. In addition, with component 520 which is oriented in such a manner that flat surface 533 is directed upwards, since flat surface 533 constitutes the holding surface of component 520, and flat surface 533 is inclined, an inclination angle of flat surface 533, for example, 30°, is inputted into input box area 552b on input screen 550.

Then, a holding operation of components 520 which are scattered on stage 156 is executed by making use of the holding height of component 520, the inclination angle of the holding surface, and the height dimensions of the four sides of flat surface 533 of component 520 which are inputted into input screen 550. A calculation method of calculating a holding position of component 520 which is oriented in such a manner that flat surface 533 is directed upwards and a holding operation method of component 520 so oriented are the same as those for component 520 which is oriented in such a manner that stepped surface 521 is directed upwards, and hence, the description of those methods will be omitted here. However, with the holding operation of component 520 which is oriented in such a manner that flat surface 533 is directed upwards, the pivoting angle of suction nozzle 332 is adjusted so that suction nozzle 332 stays at right angles to the inclination angle of the holding surface which is inputted into input screen 550, that is, 30°, whereafter component 520 is held by suction nozzle 332 so adjusted. In other words, the component is held after the surface of the suction port of suction nozzle 332 is adjusted to be parallel to the inclined holding surface.

As described heretofore, the holding height of component 520, the inclination angle of the holding surface, and the height dimensions of the four sides of component 520 are inputted for each orientation of the component of components 520 of one type, that is, for the orientation in which stepped surface 521 is directed upwards and the orientation in which flat surface 533 is directed upwards. As a result, components 520 which are scattered in various orientations on stage 156 can suitably be held. Components of one type means components having the same outside dimensions and further components having the same function.

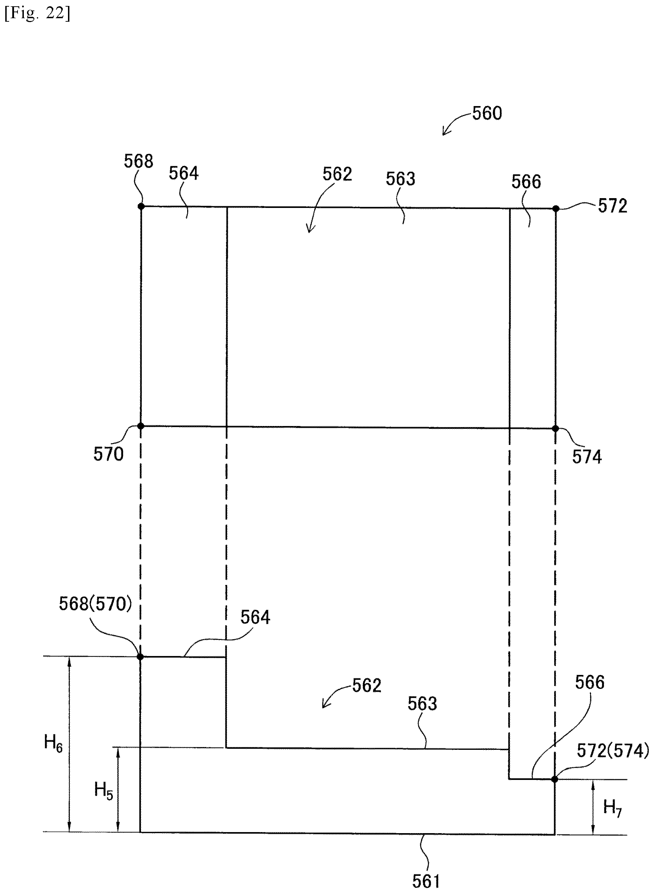

In addition, with bulk component supply device 32, components of different types can be supplied by changing the types of components which are loaded into component feeder 88. To cope with this, height dimensions of four sides of components of a type which differs from component 520, specifically, component 560 shown in Fig. 22 are allowed to be inputted on input screen 550.

Specifically speaking, in the case of component 560, a first surface of component 560 is made into flat surface 561, while a second surface is made into stepped surface 562. This stepped surface 562 is made up of center section 563 which is positioned at a center portion in a lengthwise direction, projecting section 564 which is positioned at a first end portion in the lengthwise direction, and recessed section 566 which is positioned at a second end portion of stepped surface 562 in the lengthwise direction thereof. Then, a height dimension of center section 563 is referred to as $H_5$, a height dimension of projecting section 564 is referred to as $H_6$, and a height dimension of recessed section 566 is referred to as $H_7$.

As a result, with component 560 which is oriented in such a manner that stepped surface 562 is directed upwards, height dimension $H_6$ of a side defined by only projecting section 564, that is, a side including corner portion 568 and corner portion 570 is inputted into input box area 552c on input screen 550. In addition, height dimension H7 of a side defined by only recessed section 566, that is, a side including corner portion 572 and corner portion 574 is inputted into input box area 552e. Further, height dimensions of sides defined by center section 563, projecting section 564, and recessed section 566, that is, a side including corner portion 568 and corner portion 572 and a side including corner portion 570 and corner portion 574 are inputted into input box area 552d and input box area 552f, respectively. However, since the sides defined by center section 563, projecting section 564, and recessed section 566 are each formed into a step-like shape, height dimensions of portions of the sides which occupy a larger area of the sides are inputted into input box area 552d, and input box area 552f. That is, as can be seen from Fig. 22, in the side shown therein, since the portion corresponding to center section 563 has a larger area and hence constitutes a surface suitable for component 560 to be picked up through stable suction, height dimension $H_5$ of center section 563 is inputted into input box area 552d and input box area 552f.

With component 560 which is oriented in such a manner that stepped surface 562 is directed upwards, a center of center section 563 constitutes a holding position of component 560. As a result, height dimension $H_5$ of center section 563 is inputted into input box area 552a on input screen 550 as a holding height of component 560. In addition, with component 560 which is oriented in such a manner that stepped surface 562 is directed upwards, since center section 563 constitutes a holding surface of component 560, and center section 563 constitutes a horizontal plane, 0 is inputted into input box area 552b. Then, a holding operation of components 560 which are scattered on stage 156 while being oriented in such a manner that stepped surfaces 562 are directed upwards is executed by making use of the holding height of component 560, an inclination angle of the holding surface, and the height dimensions of the four sides of the stepped surface 562 which are inputted into input screen 550. A calculation method of calculating a holding position of component 560 which is oriented in such a manner that stepped surface 562 is directed upwards and a holding operation method of component 560 so oriented are the same as those for component 520 which is oriented in such a manner that stepped surface 521 is directed upwards, and hence, the description of those methods will be omitted here.

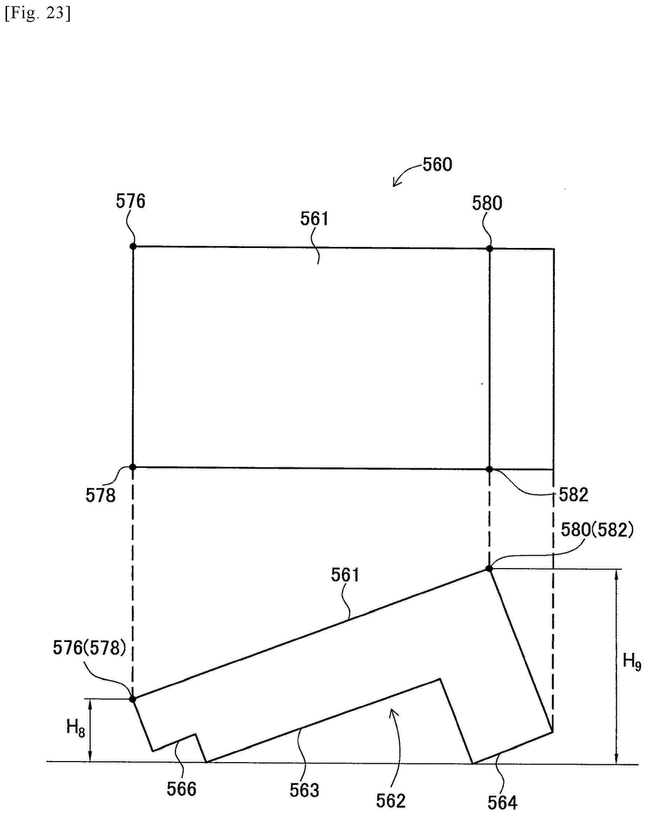

In addition, with component 560, too, as with component 520, not only is component 560 picked up by component holding head 302 when component 560 is oriented in such a state that stepped surface 562 is directed upwards but also component 560 is picked up by component holding head 302 when component 560 is oriented in such a state that flat surface 561, which is opposite to stepped surface 562, is directed upwards as shown in Fig. 23. As a result, height dimensions of four sides of component 560 which is oriented in such a manner that flat surface 561 is directed upwards are inputted on input screen 550.

Specifically speaking, also with component 560, when component 560 is oriented in such a manner that flat surface 561 is directed upwards, flat surface 561 is inclined. In this case, corner portions 576, 578 of flat surface 561 which is positioned above recessed section 566 of stepped surface 562 constitute a lowest position of flat surface 561, and height dimensions of corner portions 576, 578 are $H_8$. On the other hand, corner portions 580, 582 of flat surface 561 which is positioned above projecting section 564 of stepped surface 562 constitute a highest position of flat surface 561, and height dimensions of corner portions 580, 582 are $H_9$.

As a result, height dimension $H_8$ of the side including corner portion 576 and corner portion 578 of flat surface 561 of component 560 which is oriented in such a manner that flat surface 561 is directed upwards is inputted into input box area 552c on input screen 550. In addition, height dimension $H_9$ of the side including corner portion 580 and corner portion 582 of flat surface 561 is inputted into input box area 552e. Further, the height dimensions of the side including corner portion 576 and corner portion 580 and the side including corner portion 578 and corner portion 582 of flat surface 561 are inputted to input box area 552d and input box area 552f. However, the side including corner portion 576 and corner portion 580 and the side including corner portion 578 and corner portion 582 are inclined, and the height dimensions of the lowest portions of the sides are $H_8$, and the height dimensions of the highest portions of the sides are $H_9$. Then, average height dimensions of those sides are inputted into input box area 552d and input box area 552f, respectively. As a result, height dimension $(H_8+H_9)/2$ is inputted into input box area 552d and input box area 552f as the height dimensions of the side including corner portion 576 and corner portion 580 and the side including corner portion 578 and corner portion 582.

With component 560 which is oriented in such a manner that flat surface 561 is directed upwards, a center of flat surface 561 constitutes a holding position of component 560. As a result, a mean height dimension between the side including corner portion 576 and corner portion 578 and the side including corner portion 580 and corner portion 582, that is, height dimension $(H_8+H_9)/2$ is inputted into input box area 552a on input screen 550 as a holding height of component 560. In addition, with component 560 which is oriented in such a manner that flat surface 561 is directed upwards, since flat surface 561 constitutes a holding surface of component 560, and flat surface 561 is inclined, an inclination angle of flat surface 561, for example, 20° is inputted into input box area 552b on input screen 550.

Then, a holding operation of components 560 which are scattered on stage 156 in such an orientation that flat surface 561 is directed upwards is executed by making use of the holding height of component 560, the inclination angle of the holding surface, and the height dimensions of the four sides of flat surface 561 of component 560 which are inputted into input screen 550. A calculation method of calculating a holding position of component 560 which is oriented in such a manner that flat surface 561 is directed upwards and a holding operation method of component 560 so oriented are the same as those for component 520 which is oriented in such a manner that flat surface 533 is directed upwards, and hence, the description of those methods will be omitted here.

As described above, the holding height of the component, the inclination angle of the holding surface, and the height dimensions of the four sides of the component are inputted for each component type, that is, for each of multiple types of components. As a result, in the case that components of an arbitrary type in components of multiple types are loaded in component feeder 88, a holding operation of components of the arbitrary type can suitably be carried out. Components of multiple types mean components having different shapes, different external dimensions, and the like. In addition, there may be a case in which components of multiple types mean components having different functions. Further, for each of components of those different types, the holding height of the component, the inclination angle of the holding surface, and the height dimensions of the four sides of the component are inputted for each of multiple orientations of scattered components. As a result, even for components of an arbitrary type of components of multiple types, components scattered on stage 156 in various orientations can suitably be held.

Bulk component supply device 32 constitutes an example of the component holding apparatus of the present invention. Stage 156 constitutes an example of the stage. Camera 290 constitutes an example of the imaging device.

In addition, in the embodiment described above, the height dimensions of the four sides of the surface of the component which is directed upwards are inputted on input screen 550 as multiple different height dimensions in one orientation of the components of one type; however, the different height positions of two or more sides in the four sides may be inputted. Further, not only the sides but also the corner portions of the surface directed upwards may be inputted. Furthermore, not only the height dimensions of the surface of the component which is directed upwards but also height dimensions of one or more arbitrary surfaces of the multiple surfaces of the component can be inputted For example, in the case that the suction nozzle is adopted as a component holding tool, since the surface of the component which is directed upwards constitutes the holding surface in many cases, the height dimensions of the surface of the component which is directed upwards are inputted; however, in the case that a chuck is adopted as a component holding tool, since a surface of the component which is directed sideways constitutes the holding surface in many cases, the height dimensions of the surface of the component which is directed sideways may be inputted. However, not only the height dimensions of the holding surface but also height dimensions of one or more arbitrary surfaces of the multiple surfaces of the component can be inputted.

In the embodiment described above, the component is held by suction nozzle 332; however, the holding surface can be held by adopting holding tools of various aspects configured to hold a component such as a chuck which can hold a component, a robot arm, and the like.

In the embodiment described above, the two-dimensional camera is adopted on which the lens which differs from a telecentric lens is mounted; however, a three-dimensional camera, a two-dimensional camera on which a telecentric lens is mounted, and the like can be adopted. In addition, a configuration may be adopted in which multiple cameras are used, or the position of one camera is moved or the angle of the camera is changed so as to execute imaging multiple times, so that orientations of components which are scattered are determined based on image data captured by the imaging. Alternatively, two-dimensional images may be obtained by these various types of imaging devices.

In addition, the holding angle of a component described in the embodiment may automatically be calculated. That is, the angle of the holding surface may be calculated from the height data of each of the components which are oriented when they are scattered by the control device. Alternatively, the input and storage of the height data of each of the components which are oriented when they are scattered may be omitted by making use of the position of each of the components which are scattered and the angle data of the holding surface when each of the components so scattered is held.

In the embodiment described above, the present invention is applied to bulk component supply device 32; however, in addition to the device for supplying components, the present invention can be applied to a device for holding a component and executing a mounting operation of the component, a device for only holding a component, and the like.

In addition, in the present invention, the holding target components are not limited to components 520, 560, and the like, and hence, the present invention can be applied to various types of components. Specifically speaking, the present invention can be applied to, for example, constituent components of a solar cell, constituent components of a power module, electronic circuit components with leads, electronic circuit components without leads, chip-type small electronic components, and the like.

Reference Signs List

32: bulk component supply device (component holding apparatus), 156: stage, 290: camera (imaging device)

## Claims

1. A component holding apparatus (32) comprising:

   a stage (156) with a horizontal upper surface on which components (410) of one type are scattered;
   **characterized in that** the component holding apparatus further comprises:

   an input screen (550) configured to input multiple heights of the components of one type;
   a two-dimensional imaging device (290) configured to perform fixed-point imaging at a predetermined height above the stage and to image the components of one type which are scattered on the stage; and
   a means configured to calculate a holding position based on the inputted multiple heights and on image data of the imaged components of one type,
   wherein the components of one type which are scattered on the stage are held based on the calculated holding position.

2. The component holding apparatus according to claim 1,
   wherein the multiple height dimensions are inputted for each of orientations of the components of one type which are scattered on the stage.

3. The component holding apparatus according to claim 1,
   wherein the multiple height dimensions are inputted for each component type of the components of one type which are scattered on the stage.

4. The component holding apparatus according to claim 3,
   wherein the multiple height dimensions are also inputted for each of orientations of the components of one type which are scattered on the stage.

5. The component holding apparatus according to any one of claims 1 to 4,
   wherein the multiple height dimensions are height dimensions of at least one plane of multiple planes of one component of the components of one type which are scattered on the stage while being oriented.

## Patentansprüche

1. Vorrichtung (32) zum Aufnehmen von Bauteilen, die umfasst:

   einen Tisch (156) mit einer horizontalen oberen Fläche, auf der Bauteile (410) eines Typs verteilt sind;
   **dadurch gekennzeichnet, dass** die Vorrichtung zum Aufnehmen von Bauteilen des Weiteren umfasst:

   einen Eingabebildschirm (550), der zum Eingeben mehrerer Höhen der Bauteile eines Typs ausgeführt ist;
   eine Einrichtung (290) zum Erzeugen zweidimensionaler Bilder, die so ausgeführt ist, dass sie Festpunkt-Bilderzeugung in einer vorgegebenen Höhe über dem Tisch durchführt und ein Bild der auf dem Tisch verteilten Bauteile eines Typs erzeugt; sowie ein Mittel, das zum Berechnen einer Aufnahmeposition auf Basis der eingegebenen mehreren Höhen sowie von Bilddaten der Bauteile eines Typs ausgeführt ist, deren Bild erzeugt worden ist,
   wobei die Bauteile eines Typs, die auf dem Tisch verteilt sind, auf Basis der berechneten Aufnahmeposition aufgenommen werden.

2. Vorrichtung zum Aufnehmen von Bauteilen nach Anspruch 1,
   wobei die mehreren Höhenabmessungen für jede von Ausrichtungen der Bauteile eines Typs eingegeben werden, die auf dem Tisch verteilt sind.

3. Vorrichtung zum Aufnehmen von Bauteilen nach Anspruch 1,
   wobei die mehreren Höhenabmessungen für jeden Bauteiltyp der Bauteile eines Typs eingegeben werden, die auf dem Tisch verteilt sind.

**4.** Vorrichtung zum Aufnehmen von Bauteilen nach Anspruch 3,
wobei die mehreren Höhenabmessungen auch für jede von Ausrichtungen der Bauteile eines Typs eingegeben werden, die auf dem Tisch verteilt sind.

**5.** Vorrichtung zum Aufnehmen von Bauteilen nach einem der Ansprüche 1 bis 4,
wobei die mehreren Höhenabmessungen Höhenabmessungen wenigstens einer Ebene von mehreren Ebenen eines Bauteils der Bauteile eines Typs sind, die auf dem Tisch verteilt und dabei ausgerichtet sind.

## Revendications

**1.** Appareil de maintien de composants (32) comprenant :

un étage (156) avec une surface supérieure horizontale sur laquelle des composants (410) d'un premier type sont dispersés ;
**caractérisé en ce que** l'appareil de maintien de composants comprend en outre :

un écran de saisie (550) configuré pour saisir de multiples hauteurs des composants du premier type ;
un dispositif d'imagerie bidimensionnelle (290) configuré pour effectuer une imagerie en point fixe à une hauteur prédéterminée au-dessus de l'étage et pour imager les composants du premier type qui sont dispersés sur l'étage ; et
un moyen configuré pour calculer une position de maintien sur la base des multiples hauteurs saisies et de données d'image des composants imagés du premier type,
dans lequel les composants du premier type qui sont dispersés sur l'étage sont maintenus sur la base de la position de maintien calculée.

**2.** Appareil de maintien de composants selon la revendication 1,
dans lequel les multiples dimensions de hauteur sont saisies pour chacune des orientations des composants du premier type qui sont dispersés sur l'étage.

**3.** Appareil de maintien de composants selon la revendication 1,
dans lequel les multiples dimensions de hauteur sont saisies pour chaque type de composant des composants du premier type qui sont dispersés sur l'étage.

**4.** Appareil de maintien de composants selon la revendication 3,
dans lequel les multiples dimensions de hauteur sont également saisies pour chacune des orientations des composants du premier type qui sont dispersés sur l'étage.

**5.** Appareil de maintien de composants selon l'une quelconque des revendications 1 à 4,
dans lequel les multiples dimensions de hauteur sont des dimensions de hauteur d'au moins un plan parmi de multiples plans d'un composant parmi les composants du premier type qui sont dispersés sur l'étage tout en étant orientés.

[Fig. 1]

[Fig. 2]

[Fig. 3]

[Fig. 4]

[Fig. 5]

[Fig. 6]

[Fig. 7]

[Fig. 8]

EP 4 027 763 B1

[Fig. 9]

EP 4 027 763 B1

[Fig. 10]

[Fig. 11]

[Fig. 12]

[Fig. 13]

[Fig. 14]

[Fig. 15]

[Fig. 16]

[Fig. 17]

EP 4 027 763 B1

[Fig. 18]

33

[Fig. 19]

550

HOLDING HEIGHT(mm)    552a

INCLINATION ANGLE( ° )    552b

UPPER SIDE HEIGHT(mm)    552c

LEFT SIDE HEIGHT(mm)    552d

LOWER SIDE HEIGHT(mm)    552e

RIGHT SIDE HEIGHT(mm)    552f

[Fig. 20]

[Fig. 21]

[Fig. 22]

[Fig. 23]

**EP 4 027 763 B1**

**REFERENCES CITED IN THE DESCRIPTION**

**Patent documents cited in the description**

- US 20170196131 A1
- WO 2015186188 A
- JP 2016219473 A